# FASCICULE DE BREVET EUROPEEN

(11) **EP 3 420 583 B1**
(45) Date de publication et mention de la délivrance du brevet: **04.08.2021**
(21) Numéro de dépôt: 17710350.4
(22) Date de dépôt: 23.02.2017
(51) Int. Cl.: H01L 21/762, H01L 21/02

(54) **SUPPORT POUR UNE STRUCTURE SEMI-CONDUCTRICE**
TRÄGER FÜR EINE HALBLEITERSTRUKTUR
CARRIER FOR A SEMICONDUCTOR STRUCTURE

(30) Priorité: 26.02.2016 FR 1651642
(43) Date de publication de la demande: 02.01.2019
(73) Titulaire: Soitec, 38190 Bernin (FR); Université Claude Bernard Lyon 1, 69100 Villeurbanne (FR); Centre National de la Recherche Scientifique, 75794 Paris Cedex 16 (FR)
(72) Inventeur: FIGUET, Christophe, 38920 Crolles (FR); KONONCHUK, Oleg, 38570 Theys (FR); ALASSAAD, Kassam, Jarfàlla 17744, (SE); FERRO, Gabriel, 69100 Villeurbanne (FR); SOULIERE, Véronique, 38080 Saint Marcel Bel Accueil (FR); VEYTIZOU, Christelle, 38190 Bernin (FR); YEGHOYAN, Taguhi, 38300 Bourgoin-Jallieu (FR)
(74) Mandataire: IP Trust
(86) Numéro de dépôt international: PCT/FR2017/050400
(87) Numéro de publication internationale: WO 2017/144821

(56) Documents cités:
- US-A1- 2006 073 674
- US-A1- 2010 171 195
- US-A1- 2013 168 835
- US-A1- 2015 115 480

## Description

### DOMAINE DE L'INVENTION

La présente invention concerne un support pour une structure semi-conductrice.

### ARRIERE PLAN TECHNOLOGIQUE DE L'INVENTION

Les dispositifs intégrés sont usuellement formés sur des substrats qui servent principalement de support à leur fabrication. Toutefois, l'accroissement du degré d'intégration et des performances attendues de ces dispositifs entraine un couplage de plus en plus important entre leurs performances et les caractéristiques du substrat sur lequel ils sont formés. C'est particulièrement le cas des dispositifs RF, traitant des signaux dont la fréquence est comprise entre environ 3kHz et 300GHz, qui trouvent notamment leur application dans le domaine des télécommunications (téléphonie, Wi-Fi, Bluetooth...) .

A titre d'exemple de couplage dispositif/substrat, les champs électromagnétiques, issus des signaux hautes fréquences se propageant dans les dispositifs intégrés, pénètrent dans la profondeur du substrat et interagissent avec les éventuels porteurs de charge qui s'y trouvent. Il s'en suit une consommation inutile d'une partie de l'énergie du signal par perte de couplage et des influences possibles entre composants par diaphonie (« crosstalk » selon la terminologie anglo-saxonne).

Selon un second exemple de couplage, les porteurs de charges du substrat peuvent entrainer la génération d'harmoniques non voulues, pouvant interférer avec les signaux se propageant dans les dispositifs intégrés et dégradant leurs qualités.

Ces phénomènes sont notamment observables lorsque le substrat employé comprend une couche enterrée d'isolant, entre un support et une couche utile sur et dans laquelle sont formés les dispositifs intégrés. Les charges piégées dans l'isolant conduisent à accumuler sous cette couche d'isolant, dans le support, des charges de signes complémentaires formant un plan conducteur. Dans ce plan conducteur, les charges mobiles sont susceptibles d'interagir fortement avec les champs électromagnétiques générés par les composants de la couche utile.

Pour se prémunir ou limiter ce phénomène, il est connu d'insérer entre l'isolant enterré et le support, directement sous l'isolant, une couche de piégeage de charges, par exemple une couche de 1 à 5 microns de silicium polycristallin. Les joints des grains formant le poly cristal constituent alors des pièges pour les porteurs de charges, ceux-ci pouvant provenir de la couche de piégeage elle-même ou du support sous-jacent. De la sorte, on prévient l'apparition du plan conducteur sous l'isolant.

Le couplage dispositif/substrat dépend alors de l'intensité d'interaction des champs électromagnétiques avec les charges mobiles du support. La densité et/ou la mobilité de ces charges sont fonction de la résistivité du support.

Lorsque la résistivité du substrat est relativement importante (et donc une densité de charge relativement peu importante), supérieure à 1000 ohm.cm, une couche de piégeage de 1 à 5 microns d'épaisseur peut être adaptée pour limiter le couplage dispositif/substrat. On préserve ainsi l'intégrité des signaux, et donc la performance radiofréquence des dispositifs intégrés de la couche utile.

Lorsque, au contraire, la résistivité du substrat est plus faible, inférieure à 1000 ohm.com, ou lorsque la performance attendue du dispositif intégré est élevée, il serait souhaitable de pouvoir former une couche de piégeage très épaisse, supérieure à 5 microns, voire à 10 ou 15 microns, pour repousser plus en profondeur dans le substrat la zone dans laquelle les charges sont mobiles. On pourrait ainsi prévenir les interactions avec les champs électromagnétiques se propageant très profondément, et améliorer encore la performance des dispositifs intégrés de la couche utile.

Toutefois, il a été observé qu'une épaisseur de couche de piégeage supérieure à 5 microns ne conduisait pas à l'amélioration de performance attendue.

Le document US 20150115480 divulgue un substrat comprenant un support pour une structure semi-conductrice, le support étant muni d'une couche de piégeage formée d'un empilement de couches polycristallines ou amorphes de silicium, de silicium germanium, de carbure de silicium et/ou de germanium. Ces couches sont passivées, c'est-à-dire que leurs interfaces sont constituées d'une fine couche d'isolant tel qu'un oxyde de silicium ou de nitrure de silicium. Une telle passivation est obtenue, selon ce document, en exposant la surface libre de ces couches au cours de leur fabrication, à un environnement riche en oxygène ou en azote.

Selon ce document, la structure multicouche de la couche de piégeage permettrait de prévenir le phénomène de recristallisation de la couche polycristalline de piégeage lorsque le substrat est exposé à une très haute température, par exemple lors de sa fabrication ou de la fabrication de dispositifs intégrés sur ce substrat. Lorsque la couche de piégeage se recristallise, même partiellement, on affecte les performances RF du substrat et des dispositifs intégrés qui y seront formés, ce qui n'est bien sûr pas souhaitable.

Le support proposé par ce document ne donne toutefois pas entière satisfaction.

En premier lieu, les fines couches d'isolant de passivation que ce document envisage de former ne sont généralement pas stables en température, notamment lorsque cet isolant est du dioxyde de silicium. Une exposition à haute température du support peut conduire à la dissolution de l'oxyde dans les couches polycristallines, et à la disparition des couches de passivation. Les couches de piégeage sont alors susceptibles de se recristalliser si le traitement à haute température du support se poursuit.

Si ces couches de passivation isolantes sont formées avec suffisamment d'épaisseur pour assurer leur stabilité en température, elles forment alors des barrières à la diffusion des charges présentent dans le support et dans les couches de l'empilement. Lorsque les pièges d'une couche de l'empilement sont tous saturés en porteurs de charges, ceux-ci restent confinés dans la couche et s'y accumulent, et ne peuvent être entrainés vers d'autres pièges disponibles dans d'autres couches de l'empilement. Les performances RF du substrat en sont donc détériorées.

De plus, les charges piégées dans les couches de passivation isolantes relativement épaisses conduisent à former des plans conducteurs sous leur surface, reproduisant les phénomènes observés sous une couche d'oxyde enterré d'une structure SOI qui ont été décrits antérieurement. La structure polycristalline des couches de piégeage ne peut que partiellement compenser cette quantité de charges additionnelles. A nouveau, les performances RF du substrat en sont détériorées.

### OBJET DE L'INVENTION

La présente invention vise à pallier tout ou partie des inconvénients précités.

### BREVE DESCRIPTION DE L'INVENTION

En vue de la réalisation de l'un de ces buts, l'objet de l'invention propose un support pour une structure semi-conductrice comprenant une couche de piégeage de charges disposée sur un substrat de base. Selon l'invention la couche de piégeage est constituée d'une couche principale polycristalline en silicium et, intercalée dans la couche principale ou entre la couche principale et le substrat de base, d'au moins une couche intercalaire composée d'un alliage de silicium et de carbone ou de carbone, la couche intercalaire présentant une résistivité supérieure à 1000 ohm.cm.

La couche de piégeage est de la sorte stable en température, sans présenter les inconvénients des couches de passivation isolantes de l'état de la technique.

Selon d'autres caractéristiques avantageuses et non limitatives de l'invention, prises seules ou selon toute combinaison techniquement réalisable :
- le substrat de base présente une résistivité supérieure à 1000 ohm.cm ;
- la couche de piégeage présente une épaisseur supérieure à 10 microns ;
- Le support comprend entre 1 et 10 couches intercalaires;
- la couche principale polycristalline est constituée de grains de silicium de taille comprise entre 100 nm et 1000 nm ;
- chaque couche intercalaire présente une épaisseur inférieure à 10nm ou à 5nm ;
- Le support comprend une couche d'isolant sur la couche de piégeage de charges ;
- la (ou les) couche intercalaire polycristalline est composée d'un alliage de silicium et de carbone présentant plus de 5% de carbone, comme du carbure de silicium.

L'objet de l'invention porte également sur une structure semi-conductrice comprenant un tel support, une couche d'isolant sur le support et une couche utile sur la couche d'isolant. La couche utile peut contenir au moins un composant.

L'objet de l'invention porte finalement sur un procédé de fabrication d'une structure semi-conductrice comprenant les étapes suivantes :
a. fournir un support tel que précédemment décrit ;
b. former, sur ce support, la structure semi-conductrice.

L'étape b de formation peut comprendre le transfert d'une couche utile sur le support.

La couche utile peut comprendre au moins un dispositif intégré.

### BREVE DESCRIPTION DES DESSINS

D'autres caractéristiques et avantages de l'invention ressortiront de la description détaillée de l'invention qui va suivre en référence aux figures annexées sur lesquels :
- La figure 1 représente schématiquement un support pour une structure semi-conductrice conforme à l'invention ;
- la figure 2 représente la relation existante entre l'épaisseur d'une couche polycristalline et la taille moyenne des grains en surface de cette couche ;
- la figure 3 représente un substrat du type semi-conducteur sur isolant comportant un support conforme à l'invention.

### DESCRIPTION DETAILLEE DE L'INVENTION

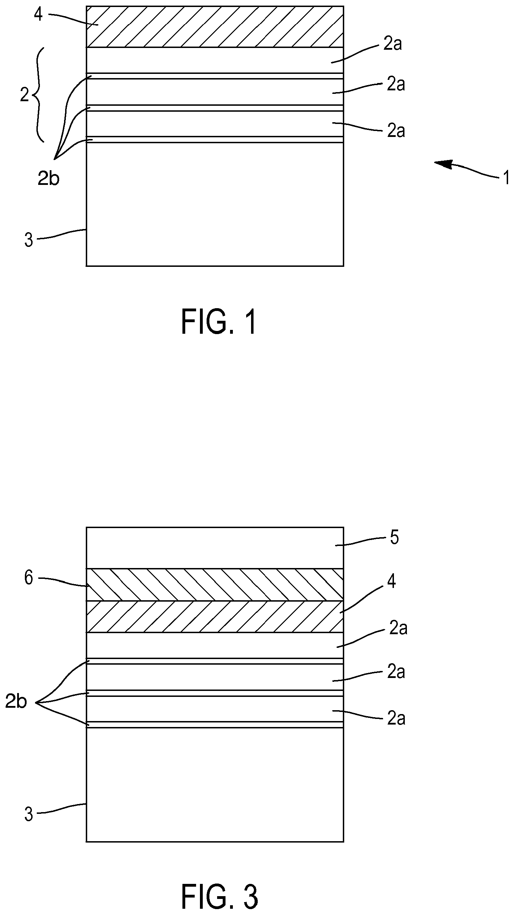

La figure 1 représente schématiquement un support pour une structure semi-conductrice conforme à l'invention. Le support 1 peut avoir la forme d'une plaquette, circulaire, de dimension normalisée, par exemple de 200 mm ou 300 mm, voire 450 mm de diamètre. Mais l'invention n'est nullement limitée à ses dimensions ou à cette forme.

Ainsi, dans le cas où la structure semi-conductrice serait un dispositif intégré fini ou semi-fini, le support 1 prendra la forme d'un bloc de matériau de section longitudinale rectangulaire ou carré dont les dimensions, de quelques millimètres à quelques centimètres, correspondent aux dimensions du dispositif intégré.

Le support 1 comprend un substrat de base 3, typiquement de plusieurs centaines de microns d'épaisseur. Préférentiellement, et notamment lorsque le support 1 a vocation à recevoir une structure semi-conductrice dont les performances RF attendues sont élevées, le substrat de base présente une résistivité élevée, supérieure à 1000 ohm.centimètre, et plus préférentiellement encore supérieure à 3000 ohm.centimètre. On limite de la sorte la densité des charges, trous ou électrons, qui sont susceptibles de se déplacer dans le substrat de base. Mais l'invention n'est pas limitée à un substrat de base présentant une telle résistivité, et elle procure également des avantages de performance RF lorsque le substrat de base présente une résistivité plus conforme, de l'ordre de quelques centaines d'ohm.centimètres ou moins.

Pour des raisons de disponibilité et de coût, le substrat de base est préférentiellement en silicium. Il peut s'agir par exemple d'un substrat CZ à faible teneur en oxygène interstitiel qui présente, comme cela est bien connu en soi, une résistivité qui peut être supérieure à 1000 ohm.centimètre. Le substrat de base peut alternativement être formé d'un autre matériau : il peut s'agir par exemple de saphir, de carbure de silicium, ....

Le support 1 comporte également, directement en contact avec le substrat de base 3, une couche de piégeage 2. Comme cela a été évoqué dans le détail en introduction de la présente demande, la couche de piégeage a pour fonction de piéger les porteurs de charges pouvant être présents dans le support 1 et de limiter leur mobilité. C'est notamment le cas lorsque le support 1 est muni d'une structure semi-conductrice émettant un champ électromagnétique pénétrant dans le support et donc susceptible d'interagir avec ces charges.

Selon l'invention, la couche de piégeage 2 comprend une couche principale polycristalline 2a.

Pour les mêmes raisons de disponibilité et de coût qui ont déjà été évoquées, la couche principale 2a est en silicium polycristallin.

La couche principale 2a présente une résistivité élevée supérieure à 3000 ohm.centimètre. À cette fin, la couche principale 2a n'est pas intentionnellement dopée, c'est-à-dire qu'elle présente une concentration en dopant inférieure à 10 E14 atomes par centimètre cube. Elle peut être riche en azote ou en carbone afin d'améliorer sa caractéristique de résistivité.

La couche de piégeage 2 comprend également, intercalée dans la couche principale 2a ou entre la couche principale 2a et le substrat de base 3, au moins une couche intercalaire 2b composée d'un alliage de silicium et de carbone ou de carbone, présentant une résistivité supérieure à 1000 ohms.centimètre. Il s'agit de matériaux très stables en température, c'est-à-dire que même exposé à des températures très élevées dépassant celles qui sont généralement utilisées pour la fabrication de structures semi-conductrices (500° à 1300°), ces matériaux préservent leur structure micro et macroscopique. Comme cela sera détaillé plus en détail par la suite, l'alliage de silicium et de carbone, ou le carbone constituant la couche intercalaire peut être formée par dépôt de silicium et de carbone ou par carbonisation de surface. Elle est généralement de nature polycristalline, mais lorsqu'elle est formée par carbonisation d'un substrat de base 3 cristallin, elle peut présenter une nature cristalline ou partiellement cristalline.

On précise que selon l'invention la couche de piégeage 2 est constituée de la couche principale 2a et d'au moins une couche intercalaire 2b. Il n'est pas prévu d'incorporer d'autre couches, notamment des couches d'isolant électrique, qui pourraient venir modifier les propriétés avantageuses de la couche de piégeage proposée.

En intercalant au moins une couche intercalaire 2b dans la couche principale polycristalline 2a ou sous cette couche, on forme un empilement stable en température qui prévient la recristallisation de la couche principale polycristalline 2a lors des traitements thermiques que le support 1 peut subir.

S'agissant de matériaux semi-conducteurs résistifs, on pallie aux inconvénients liés à l'usage d'un matériau isolant. De plus, leurs propriétés de résistivité et de polycristallinité contribuent au piégeage des charges dans la couche 2, similairement à ce qui se produit dans la couche principale 2a.

Lorsque le support 1 comporte plusieurs couches intercalaires 2b, celles-ci peuvent être de même nature ou de nature différente, cette nature restant choisie dans la liste des matériaux précités.

La couche de piégeage 2 constituée, sur un substrat de base, de la couche principale 2a et d'au moins une couche intercalaire 2b, forme donc un support pour une structure semi-conductrice stable en température, c'est-à-dire peu sujet à la recristallisation, et efficace pour le piégeage des porteurs de charge. Elle présente en effet une densité très importante de pièges accessibles aux charges.

De plus, en intercalant de la sorte au moins une couche 2b dans la couche principale 2a, il a été observé, de manière surprenante, qu'il était possible de former une couche de piégeage 2 d'épaisseur supérieure à 2 microns, permettant d'améliorer les performances RF du support.

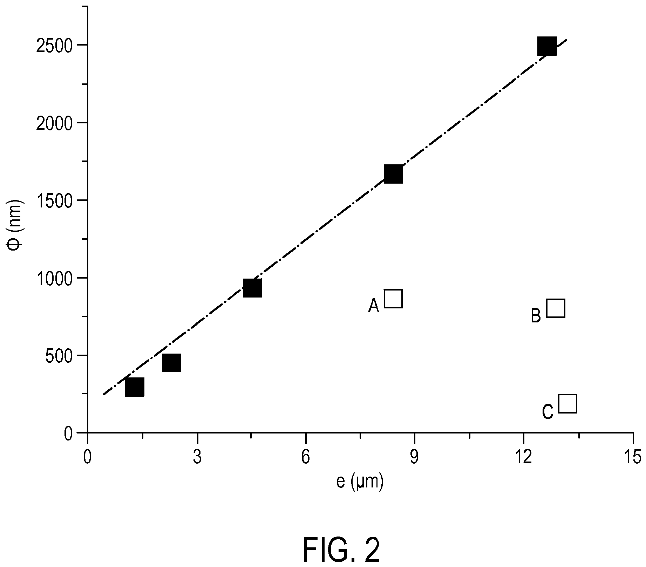

Cette propriété est illustrée en référence à la figure 2 dont la description suit. Sur des substrats de silicium CZ standard, on a formé des couches de silicium polycristallines selon l'état de la technique et d'épaisseur croissante. Pour chacune de ces couches, et à leurs surfaces, on a relevé la taille moyenne des grains du polycristal par imagerie SEM (acronyme de l'expression Anglo-saxonne « Surface Electron Microscopy », microscopie électronique à balayage).

Le graphe de la figure 2 représente (sous la forme de carré noir) la relation existante entre l'épaisseur d'une couche polycristalline (en abscisse et en microns) et la taille moyenne des grains en surface de cette couche (en ordonnée et en nanomètres). On observe que plus la couche est épaisse et plus les grains sont de tailles importantes.

Une couche de piégeage épaisse peut être souhaitée pour repousser plus en profondeur du support la zone résiduelle de porteurs de charge. Mais cela entraîne, comme on l'observe, une augmentation de la taille des grains en surface de la couche de piégeage. Cette surface est destinée à être placée juste sous la structure semi-conductrice, elle est donc susceptible d'être soumise à un champ magnétique important. La performance RF de la structure semi-conductrice sera donc très sensible au comportement des porteurs de charges au niveau de cette surface et à sa proximité.

Or, une augmentation de la taille des grains pose problème à deux titres. Tout d'abord, des grains de plus grandes tailles entrainent une densité de joints de grain moindre. Ces joints formant une zone privilégiée de piégeage des porteurs, la densité de pièges est réduite.

D'autre part, les grains forment également un espace de confinement pour les porteurs de charge qui y résident. Dans des grains de dimension importante, par exemple de l'ordre de grandeur d'un dispositif intégré, les charges se comportent, vues du dispositif, comme dans un matériau sans défaut.

Ces deux aspects se combinent pour diminuer la performance RF du support, lorsque les grains du poly cristal de la couche de piégeage sont de tailles importantes.

Des études complémentaires ont montré que la dimension des grains doit être préférentiellement comprise entre 100 nm (en deçà de laquelle leur stabilité thermique n'est plus assurée et où l'on risque leur recristallisation en température) et 1000 nm (au-delà de laquelle la performance RF du support est affectée). Cette caractéristique de grains n'a jamais pu être obtenue pour une épaisseur de la couche de piégeage supérieure à environ 5 microns, et sur toute ton épaisseur.

Sur un substrat de base identique à celui de l'exemple précédent, on a formé une couche intercalaire de silicium polycristallin d'environ huit microns. A mi-épaisseur de cette couche, on a formé une couche polycristalline de carbure de silicium de 1nm. La taille de grain en surface de la couche de silicium polycristallin a été mesurée de l'ordre de 800 nm.

Sur un deuxième substrat de base, on a formé une couche de silicium polycristallin d'environ 13 microns. Cinq couches de carbure de silicium de 80 nm ont été intercalées régulièrement dans la couche polycristalline. La taille des grains en surface de cette couche a été mesurée de l'ordre de 800 nm.

Sur un troisième substrat de base, on a formé une couche de silicium polycristallin d'environ 13 microns. Onze couches de carbures de silicium d'épaisseur 40 nm ont été intercalées régulièrement dans la couche polycristalline. La taille de grain en surface de cette couche a été mesurée de l'ordre de 125 nm.

Les trois mesures ont été placées sur le graphe de la figure 2 et respectivement repérés A, B, C sur ce graphe.

Il est très apparent sur cette figure que l'insertion des couches intercalaires permet de contrôler l'évolution de la taille des grains dans l'épaisseur de la couche de piégeage, et qu'il est possible d'obtenir des grains de tailles comprises entre 100 et 1000 nanomètres, même pour des épaisseurs de couches supérieures à 5 ou 10 microns.

Selon une hypothèse (non limitative) d'interprétation de ces résultats, la (ou les) couche intercalaire composée d'un alliage de silicium et de carbone présente une différence de paramètre de maille importante avec le silicium polycristallin de la couche principale (le paramètre de maille de la couche intercalaire étant plus petit que celui de la couche principale). On génère de la sorte une densité très importante de défauts cristallins, et on perd la relation d'épitaxie entre les couches de poly-silicium et la couche intercalaire au cours de leurs croissances. L'arrangement polycristallin particulier de la couche principale sous une couche intercalaire est perdu, et n'est pas reproduit dans la portion de la couche principale au dessus de la couche intercalaire.

Ces observations permettent d'établir des caractéristiques avantageuses de la couche de piégeage 2 conforme à l'invention.

Ainsi la couche de piégeage peut avantageusement comporter entre 1 et 10 couches intercalaires. On peut contrôler de la sorte, et sans former un empilement excessivement complexe et coûteux, la taille des grains de la couche de piégeage 2a, mêmes pour des épaisseurs de couches de piégeage 2 importantes, supérieures à 5 microns, et voir même supérieure à 10 microns.

De préférence, chaque couche intercalaire 2b formée d'un alliage de silicium et de carbone ou formée de carbone, présente un paramètre de maille inférieur au paramètre de maille du matériau (ou des matériaux) formant la couche principale 2a.

Avantageusement, l'épaisseur de la portion de couche principale 2a comprise entre deux couches intercalées 2b successives peut être comprise entre 0,2 et 2,5 micron. On évite ainsi que les grains deviennent de taille trop importante dans la partie supérieure de cette portion.

La couche de piégeage 2 peut présenter une épaisseur supérieure à 2, voire à 10 microns. Que son épaisseur soit supérieure ou inférieure à ces limites, la couche principale 2a peut être composée de grain dont la taille est comprise entre 100 et 1000 nanomètres. On obtient alors un support 1 présentant des performances RF très améliorées par rapport à ce qu'il est possible d'obtenir avec les supports selon l'état de la technique.

Un alliage de silicium et de carbone, ou le carbone, formant la ou les couche(s) intercalaire(s), peut présenter un coefficient de dilatation thermique très différent de celui formant la couche principale 2a. Il est dans ce cas préférable de limiter leur épaisseur, par exemple inférieur à 10 ou 5 nm. On évite de la sorte de créer des contraintes dans le support 1 lorsque celui-ci est soumis à une température élevée.

L'alliage de silicium et de carbone peut correspondre à du carbure de silicium, ou à du silicium dopé carbone. Préférentiellement, le silicium dopé carbone présente plus de 5% de carbone.

Finalement, et comme cela est représenté sur la figure 1, le support peut présenter une couche d'isolant 4 directement sur la couche de piégeage 2. Cette couche d'isolant 4, optionnelle, peut faciliter l'assemblage du support 1 avec une structure semi-conductrice.

La fabrication du support 1 selon l'invention est particulièrement simple et réalisable avec des équipements de dépôt standard de l'industrie.

Selon un exemple, on fournit le substrat de base 3 que l'on place dans une chambre de dépôt conventionnel. Comme cela est bien connu en soi, le substrat de base 3 peut être préparé avant son dépôt, par exemple pour éliminer une couche d'oxyde natif de sa surface. Cette étape n'est pas obligatoire et cet oxyde peut être préservé. Il est en effet suffisamment fin, de 1 à 2 nm, pour ne pas avoir d'effet isolant (conduction à travers cette couche par effet tunnel) dans la mesure où les traitements thermiques à venir ne l'auront pas fait complètement disparaître par dissolution.

La chambre est parcourue par un flux de gaz précurseurs, par exemple du SiH4, à une température de l'ordre de 1000°C pour faire croître la couche principale 2a, dans le cas présent en silicium polycristallin.

En des instants déterminés de ce processus de dépôt, un second gaz précurseur de carbone, peut-être introduit dans la chambre pour une durée déterminée en vue de former la ou les couches intercalaires 2b. Ce gaz précurseur peut comprendre ou être composé, à titre d'exemple, de méthane (CH4), d'éthane (C2H6), de propane (C3H8), acétylène (C2H2), d'éthylène (C2H4), ...

Le flux du premier gaz peut être interrompu pendant cet intervalle de temps, de manière à former une couche intercalaire 2b riche, ou consistant, en carbone.

Alternativement, le flux du premier gaz peut être maintenu pendant cet intervalle de temps, de manière à former une couche intercalaire 2b consistant en un alliage de silicium et de carbone. La proportion de carbone et de silicium dans cet alliage peut être contrôlée en ajustant les flux des précurseurs respectifs.

Cet enchainement peut être répété pour former la couche de piégeage 2 visée, la durée de circulation des différents flux déterminant l'épaisseur séparant les couches successives 2a, 2b.

Lorsque l'on souhaite disposer une couche intercalaire 2b en carbone sous la couche principale 2a, et en contact avec le substrat de base 3, il peut être préférable d'éliminer la couche d'oxyde natif qui pourrait recouvrir ce substrat. Et on peut exposer le substrat de base directement au second gaz précurseur de carbone, en l'absence du premier gaz précurseur, à la température d'environ 1000°C pour former la couche intercalaire en carbone 2b. Elle peut présenter une nature cristalline ou partiellement cristalline si le substrat de base 3 présente lui-même une nature cristalline.

Pour former une section 2a de la couche principale riche en carbone, cet aspect n'étant pas couvert par l'étendue des revendications, on peut également prévoir de former cette section de couche en silicium polycristallin, et de recuire cette couche dans une atmosphère riche en carbone, telle que du C3H8. Cette étape de recuit peut être réalisé in-situ dans l'équipement de dépôt en introduisant une atmosphère riche en carbone dans la chambre, suite au dépôt de la section 2a de la couche principale.

Quelles que soit les choix réalisés pour déposer la couche de piégeage 2, on dispose à l'issue de cette phase de dépôt, d'un support 1 conforme à l'invention. Celui-ci peut subir une étape facultative de polissage du côté de la couche de piégeage 2, pour fournir une surface lisse facilitant son assemblage avec une structure semi-conductrice.

Le support peut être muni d'une couche d'isolant 4, par exemple un oxyde de silicium ou un nitrure de silicium, déposés de manière conventionnelle. Cet isolant 4 peut également être poli.

Comme on l'a déjà évoqué, le support 1 a pour vocation de recevoir une structure semi-conductrice du côté de la couche de piégeage 2.

Cette structure peut être formée de multiples façons sur le support 1, mais avantageusement cette formation comprend une étape du transfert d'une couche utile 5 sur le support.

Comme cela est bien connu en soit, ce transfert est usuellement réalisé en assemblant la face d'un substrat donneur au support 1. Celui-ci peut être muni de la couche d'isolant 4 ou non. De la même manière, le substrat donneur peut avoir été muni préalablement d'une couche isolante 6 de même nature ou de nature différente de la couche d'isolant 4. Il peut s'agir par exemple d'oxyde de silicium ou de nitrure de silicium.

Après cette étape d'assemblage, le substrat donneur est réduit en épaisseur pour former la couche utile 5. Cette étape de réduction peut être réalisée par amincissement mécanique ou chimique. Il peut s'agir également d'une fracture au niveau d'une zone fragile préalablement introduite dans le substrat donneur, par exemple selon les principes de la technologie Smart Cut™.

Des étapes de finition de la couche utile 5, telles qu'une étape de polissage, un traitement thermique sous atmosphère réductrice ou neutre, une oxydation sacrificielle peuvent être enchaînés à l'étape de réduction d'épaisseur.

Lorsque le substrat donneur est un simple substrat, c'est-à-dire qu'il ne comprend pas de dispositif intégré, on forme ainsi un substrat du type semi-conducteur sur isolant, dans lequel la couche utile 5 est une couche de semi-conducteurs vierge, comprenant le support de l'invention et comme cela est représenté sur la figure 3. Le substrat peut être alors utilisé pour la formation de dispositifs intégrés.

Lorsque le substrat donneur a été préalablement traité pour former à sa surface des dispositifs intégrés, on dispose à l'issue de ce procédé une couche utile 5 qui comprend ces dispositifs.

Par structure semi-conductrice, on désigne indifféremment un dispositif intégré que celui-ci soit formé à base de matériaux semi-conducteurs ou non. Par exemple, il peut s'agir d'un dispositif de type onde acoustique de surface ou de volume, typiquement réalisé sur et dans une couche en matériau piézo-électrique, tel que du tantalate de lithium.

On désigne également par structure semi-conductrice une couche de matériaux vierge de dispositif, à base de matériau semi-conducteur ou non, et dans lequel peut être formé des dispositifs intégrés.

## Revendications

1. Support (1) pour une structure semi-conductrice comprenant une couche de piégeage de charges (2) disposée sur un substrat de base (3), la couche de piégeage (2) étant constituée d'une couche principale polycristalline (2a) en silicium et, intercalée dans la couche principale (2a) ou entre la couche principale (2a) et le substrat de base (3), d'au moins une couche intercalaire (2b), la couche intercalaire (2b) présentant une résistivité supérieure à 1000 ohm.cm, le support (1) étant **caractérisé en ce que** la au moins une couche intercalaire (2b) est composée d'un alliage de silicium et de carbone ou de carbone.

2. Support (1) selon la revendication précédente dans lequel le substrat de base (3) présente une résistivité supérieure à 1000 ohm.cm.

3. Support (1) selon l'une des revendications précédentes dans lequel la couche de piégeage (2) présente une épaisseur supérieure à 5 ou 10 microns.

4. Support (1) selon l'une des revendications précédentes comprenant entre 1 et 10 couches intercalaires (2b).

5. Support (1) selon l'une des revendications 1 à 3, comprenant une unique couche intercalaire (2b) composée de carbone entre la couche principale (2a) et le substrat de base (3).

6. Support (1) selon l'une des revendications précédentes dans lequel la couche principale poly cristalline (2a) est constituée de grains de silicium de taille comprise entre 100 nm et 1000 nm.

7. Support (1) selon l'une des revendications précédentes dans lequel chaque couche intercalaire (2b) présente une épaisseur inférieure à 10nm ou à 5nm.

8. Support (1) selon l'une des revendications précédentes, comprenant une couche d'isolant (4) sur la couche de piégeage de charges (2).

9. Support (1) selon l'une des revendications 1 à 4 ou selon l'une des revendications 6 à 8, dans lequel la ou les couche (s) intercalaire(s) (2b) est (sont) polycristalline(s) et composée(s) d'un alliage de silicium et de carbone présentant plus de 5% de carbone.

10. Support (1) selon la revendication précédente dans lequel la couche intercalaire (2b) est du carbure de silicium.

11. Structure semi-conductrice comprenant :
- un support selon l'une des revendications 1 à 10 ;
- une couche d'isolant (4, 6) sur le support ;
- une couche utile (5) sur la couche d'isolant.

12. Structure semi-conductrice selon la revendication précédente dans laquelle la couche utile (5) comprend au moins un dispositif intégré.

13. Procédé de fabrication d'une structure semi-conductrice comprenant les étapes suivantes :
a. fournir un support (1) selon l'une des revendications 1 à 10 ;
b. former, sur le support (1), la structure semi-conductrice.

14. Procédé selon la revendication précédente dans lequel l'étape b de formation comprend le transfert d'une couche utile (5) sur le support.

15. Procédé selon la revendication précédente dans laquelle la couche utile (5) comprend au moins un dispositif intégré.

## Patentansprüche

1. Träger (1) für eine Halbleiterstruktur, die eine auf einem Basissubstrat (3) angeordnete Charge-Trapping-Schicht (2) umfasst, wobei die Charge-Trapping-Schicht (2) aus einer polykristallinen Hauptschicht (2a) aus Silizium und mindestens einer innerhalb der Hauptschicht (2a) oder zwischen der Hauptschicht (2a) und dem Basissubstrat (3) eingefügten Zwischenschicht (2b) gebildet ist, wobei die Zwischenschicht (2b) einen spezifischen Widerstand von größer als 1000 Ohm-cm aufweist, wobei der Träger (1) **dadurch gekennzeichnet ist, dass** die mindestens eine Zwischenschicht (2b) aus einer Legierung aus Silizium und Kohlenstoff oder aus Kohlenstoff besteht.

2. Träger (1) nach dem vorhergehenden Anspruch, wobei das Basissubstrat (3) einen spezifischen Widerstand von größer als 1000 Ohm-cm aufweist.

3. Träger (1) nach einem der vorhergehenden Ansprüche, wobei die Charge-Trapping-Schicht (2) eine Dicke von größer als 5 oder 10 Mikrometer aufweist.

4. Träger (1) nach einem der vorhergehenden Ansprüche, umfassend 1 bis 10 Zwischenschichten (2b).

5. Träger (1) nach einem der Ansprüche 1 bis 3, umfassend zwischen der Hauptschicht (2a) und dem Basissubstrat (3) eine einzige aus Kohlenstoff bestehende Zwischenschicht (2b).

6. Träger (1) nach einem der vorhergehenden Ansprüche, wobei die polykristalline Hauptschicht (2a) aus Siliziumkörnern mit einer Größe zwischen 100 nm und 1000 nm gebildet ist.

7. Träger (1) nach einem der vorhergehenden Ansprüche, wobei jede Zwischenschicht (2b) eine Dicke von kleiner als 10 nm oder 5 nm aufweist.

8. Träger (1) nach einem der vorhergehenden Ansprüche, umfassend eine Isolierschicht (4) auf der Charge-Trapping-Schicht (2).

9. Träger (1) nach einem der Ansprüche 1 bis 4 oder nach einem der Ansprüche 6 bis 8, wobei die Zwischenschicht(en) (2b) polykristallin ist/sind und aus einer über 5 % Kohlenstoff aufweisenden Legierung aus Silizium und Kohlenstoff besteht/bestehen.

10. Träger (1) nach dem vorhergehenden Anspruch, wobei die Zwischenschicht (2b) aus Siliziumcarbid ist.

11. Halbleiterstruktur, umfassend:
- einen Träger nach einem der Ansprüche 1 bis 10;
- eine Isolierschicht (4, 6) auf dem Träger;
- eine Nutzschicht (5) auf der Isolierschicht.

12. Halbleiterstruktur nach dem vorhergehenden Anspruch, wobei die Nutzschicht (5) mindestens eine integrierte Vorrichtung umfasst.

13. Verfahren zum Herstellen einer Halbleiterstruktur, die folgenden Schritte umfassend:
a. Bereitstellen eines Trägers (1) nach einem der Ansprüche 1 bis 10;
b. Ausbilden der Halbleiterstruktur auf dem Träger (1).

14. Verfahren nach dem vorhergehenden Anspruch, wobei der Bildungsschritt b das Übertragen einer Nutzschicht (5) auf den Träger umfasst.

15. Verfahren nach dem vorhergehenden Anspruch, wobei die Nutzschicht (5) mindestens eine integrierte Vorrichtung umfasst.

## Claims

1. Carrier (1) for a semiconductor structure, comprising a charge-trapping layer (2) arranged on a base substrate (3), the trapping layer (2) consisting of a main polycrystalline layer (2a) made of silicon and at least one intermediate layer (2b) inserted in the main layer (2a) or between the main layer (2a) and the base substrate (3), the intermediate layer (2b) having a resistivity greater than 1000 ohm.cm, the carrier (1) being **characterized in that** the at least one intermediate layer (2b) is made of an alloy of silicon and carbon or of carbon.

2. Carrier (1) according to the preceding claim, wherein the base substrate (3) has a resistivity greater than 1000 ohm.cm.

3. Carrier (1) according to either of the preceding claims, wherein the trapping layer (2) has a thickness greater than 5 or 10 microns.

4. Carrier (1) according to any of the preceding claims, comprising between 1 and 10 intermediate layers (2b).

5. Carrier (1) according to any of claims 1 to 3, comprising a single intermediate layer (2b) made of carbon between the main layer (2a) and the base substrate (3).

6. Carrier (1) according to any of the preceding claims, wherein the main polycrystalline layer (2a) consists of silicon grains of a size between 100 nm and 1000 nm.

7. Carrier (1) according to any of the preceding claims, wherein each intermediate layer (2b) has a thickness of less than 10 nm or 5 nm.

8. Carrier (1) according to any of the preceding claims, comprising an insulation layer (4) on the charge-trapping layer (2).

9. Carrier (1) according to any of claims 1 to 4 or according to any of claims 6 to 8, wherein the intermediate layer or layers (2b) is or are polycrystalline and made of an alloy of silicon and carbon having more than 5% carbon.

10. Carrier (1) according to the preceding claim, wherein the intermediate layer (2b) is made of silicon carbide.

11. Semiconductor structure, comprising:
- a carrier according to any of claims 1 to 10;
- an insulation layer (4, 6) on the carrier;
- a useful layer (5) on the insulation layer.

12. Semiconductor structure according to the preceding claim, wherein the useful layer (5) comprises at least one integrated device.

13. Method for manufacturing a semiconductor structure, comprising the following steps:
a. providing a carrier (1) according to any of claims 1 to 10;
b. forming the semiconductor structure on the carrier (1).

14. Method according to the preceding claim, wherein the forming step b comprises transferring a useful layer (5) onto the carrier.

15. Method according to the preceding claim, wherein the useful layer (5) comprises at least one integrated device.
